# EUROPÄISCHE PATENTSCHRIFT

(11) **EP 3 729 630 B1**
(45) Veröffentlichungstag und Bekanntmachung des Hinweises auf die Patenterteilung: **07.02.2024**
(21) Anmeldenummer: 18825942.8
(22) Anmeldetag: 13.12.2018
(51) Int. Cl.: H02M 7/00, H05K 7/20, H05K 7/14

(54) **INVERTER FÜR EINE ELEKTRISCHE MASCHINE**
INVERTER FOR AN ELECTRICAL MACHINE
INVERSEUR POUR UNE MACHINE ÉLECTRIQUE

(30) Priorität: 21.12.2017 DE 102017223631
(43) Veröffentlichungstag der Anmeldung: 28.10.2020
(73) Patentinhaber: Robert Bosch GmbH, 70442 Stuttgart (DE)
(72) Erfinder: BINHACK, Stephan, 75438 Knittlingen (DE); KURFISS, Jochen, 75417 Lomersheim (DE)
(86) Internationale Anmeldenummer: PCT/EP2018/084741
(87) Internationale Veröffentlichungsnummer: WO 2019/121317

(56) Entgegenhaltungen:
- EP-A1- 3 109 979
- DE-A1-102015 219 476
- US-A1- 2005 040 716
- US-A1- 2012 160 596

## Beschreibung

### Stand der Technik

Die Erfindung betrifft einen Inverter. Der Inverter weist wenigstens drei Phasen zum Bestromen einer elektrischen Maschine auf. Der Inverter weist auch eine Steuereinheit und wenigstens eine eingangsseitig mit der Steuereinheit verbundene Leistungsendstufe auf. Die Steuereinheit ist ausgebildet, insbesondere pulsweitenmodulierte Steuersignale zum Ansteuern der Leistungsendstufe zu erzeugen. Die Leistungsendstufe ist bevorzugt ausgebildet, die elektrische Maschine in Abhängigkeit des Steuersignals zu bestromen.

Aus der DE11 2010 002 719 T5 ist eine Antriebsvorrichtung bekannt, bei der eine elektronische Steuereinheit Halbleitermodule und Kondensatoren aufweist, welche in der axialen Richtung eines Motors angeordnet sind.

Zudem ist aus der DE 10 2015 219 476 A1 ein gattungsgemäßer Inverter bekannt.

### Offenbarung der Erfindung

Erfindungsgemäß weist der Inverter einen Kühlkörper, und für jede Phase einen Zwischenkreiskondensator und eine Halbleiterschalter-Halbbrücke auf. Der Kühlkörper weist eine eben ausgebildete Wärmekontaktfläche auf. Die Wärmekontaktfläche ist mit der Steuereinheit und mit den Halbleiterschalter-Halbbrücken wärmeleitfähig verbunden. Der Kühlkörper weist für die Zwischenkreiskondensatoren jeweils eine Ausnehmung auf, wobei die Zwischenkreiskondensatoren jeweils in einer Ausnehmung des Kühlkörpers angeordnet sind. Die Zwischenkreiskondensatoren weisen jeweils einen Masseanschluss auf, wobei der Masseanschluss mit dem Kühlkörper elektrisch verbunden ist. Die Halbleiterschalter-Halbbrücken weisen jeweils einen Masseanschluss auf und sind mittels des Masseanschlusses mit dem Kühlkörper elektrisch verbunden. Zudem sind ein einer Phase zugeordneter Zwischenkreiskondensator und eine Halbleiterschalter-Halbbrücke, welcher derselben Phase zugeordnet ist, gemeinsam auf einer Radialverbindung zur Steuereinheit hin angeordnet. Auf diese Weise kann vorteilhaft eine sternförmige Anordnung der Bauteile des Inverters gebildet sein, wobei die Steuereinheit im Zentrum der sternförmigen Anordnung angeordnet ist. Vorteilhaft kann so ein niederinduktiver Inverter ausgebildet sein. Die Stromwege auf der Masseleitung können vorteilhaft möglichst kurz ausgebildet sein, insoweit der Kühlkörper eine elektrische Verbindungsleitung zwischen den Leistungsendstufen und den Zwischenkreiskondensatoren für das Massepotential bildet. Zwischen zueinander verschiedenen Zwischenkreiskondensatoren fließende Ausgleichsströme beim Umschalten der Phasen können so auch vorteilhaft besonders induktionsarm und verlustarm zwischen den Zwischenkreiskondensatoren hin- und herfließen.

Ferner sind die Zwischenkreiskondensatoren jeweils zylinderförmig ausgebildet. Dabei verläuft eine Zentralachse, insbesondere Längsachse der Zwischenkreiskondensatoren jeweils quer zu einer flachen Erstreckung der Wärmeleitfläche. Bevorzugt ist ein elektrischer Anschluss des Zwischenkreiskondensators, insbesondere ein positiver Anschluss des Zwischenkreiskondensators, mit der Leistungsendstufe, insbesondere einer Halbleiterschalter-Halbbrücke wirkverbunden. Der elektrische Anschluss des Zwischenkreiskondensators ist so mit einer positiven Versorgungsspannung der Halbleiterschalter-Halbbrücke verbunden. Ein Kondensatorbecher des Zwischenkreiskondensators, insbesondere ein Masseanschluss des Zwischenkreiskondensators, ist mit dem Kühlkörper elektrisch verbunden. Auf diese Weise kann der Zwischenkreiskondensator niederinduktiv mit dem Kühlkörper verbunden sein. Masseströme können so von oder zu dem Zwischenkreiskondensator bevorzugt in alle Richtungen radial um den Zwischenkreiskondensator fließen, sodass je nach Verbindungspartner mit dem Zwischenkreiskondensator in dem Kühlkörper ein möglichst kurzer Stromweg ausgebildet werden kann.

Der Zwischenkreiskondensator ist bevorzugt ein Wickelkondensator, wobei eine Wickelachse die Zentralachse bildet. Bevorzugt ist der Zwischenkreiskondensator ein Elektrolytkondensator oder ein Superkondensator.

Der Zwischenkreiskondensator kann beispielsweise in die Ausnehmung eingeschraubt sein. Dazu kann der Zwischenkreiskondensator auf einer Mantelfläche des Gehäusebechers einen Gewindegang aufweisen und der Kühlkörper kann in der Ausnehmung ein entsprechendes Gegengewinde aufweisen. Auf diese Weise kann der Zwischenkreiskondensator mit dem Kühlkörper sowohl elektrisch gut verbunden, als auch wärmeleitfähig gut verbunden werden.

Der Zwischenkreiskondensator kann in einer anderen Ausführungsform mittels eines elektrisch leitfähigen Federelements mit dem Kühlkörper verbunden sein. Der Zwischenkreiskondensator kann in einer anderen vorteilhaften Ausführungsform mittels eines elektrisch leitfähigen Wärmeleitklebstoffs in die Ausnehmung eingeklebt sein. So kann vorteilhaft eine niederohmige Verbindung, insbesondere vollflächige niederohmige Verbindung zwischen dem Gehäusebecher und dem Kühlkörper gebildet sein, bei der eine Mantelfläche des Gehäusebechers vollständig mit dem Kühlkörper in der Ausnehmung in elektrischem Wirkkontakt steht.

Die zuvor beschriebenen Ausführungsformen der elektrischen Verbindung des Zwischenkreiskondensators mit dem Kühlkörper mittels einer Kontaktfeder oder mittels eines Wärmeleitklebstoffs sind in der DE10 2011 081 283 A1 der Anmelderin beschrieben.

In einer bevorzugten Ausführungsform ist der Kondensatorbecher mit dem Kühlkörper mittels einer insbesondere umlaufenden Schweißverbindung verschweißt, insbesondere laserverschweißt oder elektroverschweißt. Der Zwischenkreiskondensator kann so besonders aufwandsgünstig in einem Durchbruch in dem Kühlkörper, welcher beispielsweise als eine sich flach erstreckende Kühlplatte, insbesondere Aluminiumplatte, ausgebildet ist, eingebracht werden. Nach einem Einbringen, insbesondere Einpressen oder Einlegen des Zwischenkreiskondensators in die Ausnehmung des Kühlkörpers kann der Kondensatorbecher an einem Becherboden insbesondere ringförmig mit dem Kühlkörper - beispielsweise mittels einer Schweißnaht oder Schweißpunkten - verschweißt werden. Der Kondensatorbecher des Zwischenkreiskondensators ist so vorteilhaft mit dem Kühlkörper mit einem kleinen elektrischen Widerstand und einem kleinen Wärmeübergangswiderstand mit dem Kühlkörper verbunden.

Der Zwischenkreiskondensator kann in einer anderen Ausführungsform einen Kondensatorwickel aufweisen, wobei der Kondensatorwickel in der Ausnehmung angeordnet ist, sodass die Ausnehmung des Kühlkörpers einen Kondensatorbecher des Zwischenkreiskondensators, bevorzugt Elektrolytkondensator oder Superkondensator bildet. Bevorzugt ist ein Elektrolyt des Zwischenkreiskondensators mit dem Kühlkörper, insbesondere einer Innenwand des Kühlkörpers, in der Ausnehmung unmittelbar in Kontakt. Auf diese Weise kann der Zwischenkreiskondensator vorteilhaft mit einem geringstmöglichen Wärmeübergangswiderstand und einem kleinstmöglichen elektrischen Übergangswiderstand mit dem Kühlkörper verbunden und in den Kühlkörper eingebettet sein.

In einer bevorzugten Ausführungsform verlaufen die elektrischen Verbindungen zwischen der Halbleiterschalter-Halbbrücke und dem Zwischenkreiskondensator in einer Verdrahtungsebene, die sich parallel zur Wärmekontaktfläche erstreckt. Weiter bevorzugt verlaufen die elektrischen Verbindungen derart nahe zum Kühlkörper, dass sich elektromagnetische Felder eines Stromes, welcher von der Halbleiterschalter-Halbbrücke zum Zwischenkreiskondensator fließt, und ein Strom, welcher von dem Zwischenkreiskondensator in dem Kühlkörper zur Leistungsendstufe fließt, elektromagnetisch einander kompensieren. Vorteilhaft kann der Inverter so eine besonders kleine EMV-Abstrahlung (EMV = ElektroMagnetische-Verträglichkeit) erzeugen. Weiter vorteilhaft kann der Inverter, insbesondere eine Kommutierzelle, umfassend eine Halbleiterschalter-Halbbrücke und einen Zwischenkreiskondensator für eine Phase, so niederinduktiv ausgebildet sein.

In einer bevorzugten Ausführungsform verlaufen die elektrischen Verbindungen, insbesondere die Signalpfade, welche sich zwischen der Steuereinheit und den Leistungsstufen erstrecken, in der Verdrahtungsebene. Auf diese Weise kann vorteilhaft ein möglichst kleiner Abstand zum Kühlkörper gebildet sein, was eine kleine EMV-Abstrahlung von den Verbindungsleitungen ausgehend bewirkt.

In einer bevorzugten Ausführungsform verläuft ein insbesondere positiver Stromleitungspfad einer Phase von der Halbleiterschalter-Halbbrücke zum Zwischenkreiskondensator, und/oder in der Verdrahtungsebene auf einer Radialverbindung zur Steuereinheit hin. Auf diese Weise kann vorteilhaft ein möglichst kurzer Strompfad zwischen der Halbleiterschalter-Halbbrücke und dem Zwischenkreiskondensator ausgebildet sein.

In einer bevorzugten Ausführungsform verläuft ein insbesondere positiver Signalpfad einer Phase von der Steuereinheit zur Halbleiterschalter-Halbbrücke hin in der Verdrahtungsebene und/oder auf der Radialverbindung zur Steuereinheit hin. Auf diese Weise kann ein möglichst kurzer Signalpfad von der Steuereinheit zur Halbleiterschalter-Halbbrücke hin ausgebildet sein. Weiter vorteilhaft können Steuersignale zueinander verschiedener Phasen durch eine so mittels der sternförmigen Anordnung räumlich gebildete Trennung geringstmöglich einander beeinflussen. Ein Übersprechen von Signalen, was zu Fehlschaltungen führen kann, ist so wirksam gedämpft oder verhindert.

In einer bevorzugten Ausführungsform des Inverters ist mittels der Steuereinheit und den Radialverbindungen zu den Halbleiterschalter-Halbbrücken hin eine sternförmige Verbindungsanordnung gebildet, wobei ein Masseanschluss der Steuereinheit in einem Zentrum oder im Bereich des Zentrums der Verbindungsanordnung angeordnet ist. Die Steuereinheit ist bevorzugt mit dem Masseanschluss mit dem Kühlkörper verbunden. Auf die Weise kann auch von der Steuereinheit zu den Halbleiterschalter-Halbbrücken hin eine besonders niederinduktive Verbindungsanordnung gebildet sein.

Bevorzugt bildet der Kühlkörper eine Masseverbindung, insbesondere eine Masseleitung, zwischen der Steuereinheit und den Halbleiterschalter-Halbbrücken, und weiter bevorzugt den Zwischenkreiskondensatoren, sodass die Masseströme über den Kühlkörper fließen können. Masseströme können beispielsweise ein Massestrom zwischen einer Halbleiterschalter-Halbbrücke und einem Zwischenkreiskondensator sein oder ein Massestrom zwischen der Steuereinheit und einer Halbleiterschalter-Halbbrücke oder zwischen der Steuereinheit und einem Zwischenkreiskondensator.

In einer bevorzugten Ausführungsform weist der Kühlkörper eine Kühlplatte auf, wobei an die Kühlplatte Kühlbecher zur Aufnahme der Elektrolytkondensatoren angeformt sind. Der Kühlkörper ist beispielsweise ein Aluminiumkühlkörper, welcher beispielsweise durch Fräsen aus einem Aluminiumblock oder mittels Aluminiumgießen erzeugt ist. Der Kühlkörper kann so vorteilhaft - im Vergleich zu einem insbesondere zylinderförmigen Massivblock - materialsparend gebildet sein, sodass die Zwischenkreiskondensatoren jeweils mit einem Längsabschnitt in der Kühlplatte angeordnet sind und ein verbleibender Längsabschnitt der Zwischenkreiskondensatoren, insbesondere eines Kondensatorbechers des Zwischenkreiskondensators, in dem Kühlbecher angeordnet ist.

In einer bevorzugten Ausführungsform erstrecken sich die Zentralachsen der Zwischenkreiskondensatoren, bevorzugt eine Wickelachse der Kondensatorwickel der Zwischenkreiskondensatoren, jeweils quer zur Verdrahtungsebene. Der Inverter kann so vorteilhaft platzsparend ausgebildet sein.

In einer anderen Ausführungsform erstrecken sich die Zentralachsen der Zwischenkreiskondensatoren, bevorzugt die Wickelachse der Kondensatorwickel der Zwischenkreiskondensatoren, jeweils parallel zur Verdrahtungsebene und auch parallel zur Wärmeleitfläche. Der Kühlkörper kann so vorteilhaft eine kleine Dickenerstreckung aufweisen, insbesondere bei Zwischenkreiskondensatoren, welche größere Längserstreckung entlang der Zentralachse aufweisen, als einen Durchmesser des Zwischenkreiskondensators.

Die Halbleiterschalter-Halbbrücken sind jeweils bevorzugt auf einem Schaltungsträger, insbesondere einem keramischen Schaltungsträger, angeordnet und mit dem Schaltungsträger verbunden. Der Schaltungsträger ist beispielsweise ein keramischer Schaltungsträger, insbesondere ein DBC-Schaltungsträger (DBC = Direct-Bonded-Copper), ein AMB-Schaltungsträger (AMB = Active-Metal-Brazed) oder ein LTCC-Schaltungsträger (LTCC = Low-Temperature-Cofired-Ceramics) oder ein HTCC-Schaltungsträger (HTCC = High-Temperature-Cofired-Ceramics).

Die Verbindungsleitungen zwischen der Halbleiterschalter-Halbbrücke und den Zwischenkreiskondensatoren, insbesondere die positiven Anschlüsse der Zwischenkreiskondensatoren, können vorteilhaft überlappungsfrei in der Verdrahtungsebene verlaufen. Bevorzugt verlaufen sämtliche Verbindungsleitungen zwischen den Halbleiterschalter-Halbbrücken und den Zwischenkreiskondensatoren und der Steuereinheit zueinander überlappungsfrei in der Verdrahtungsebene. Die Verbindungsleitungen zwischen den Halbleiterschalter-Halbbrücken und den Zwischenkreiskondensatoren beziehungsweise der Steuereinheit sind jeweils bevorzugt durch eine Bond-Drahtverbindung oder eine Bond-Bandverbindung gebildet.

Der Inverter weist beispielsweise wenigstens drei Phasen oder nur drei Phasen, wenigstens vier Phasen oder nur vier Phasen, wenigstens fünf Phasen oder nur fünf Phasen oder wenigstens sechs Phasen oder nur sechs Phasen, oder mehr als sechs Phasen auf.

Die Erfindung betrifft auch eine elektrische Maschine, insbesondere Elektromotor und/oder Generator, mit einem Inverter der vorbeschriebenen Art. Die Maschine weist einen Stator mit Statorspulen und einen insbesondere permanentmagnetisch ausgebildeten Rotor auf. Die elektrische Maschine kann Bestandteil einer Servolenkung oder eines Elektroantriebs für ein Elektrofahrzeug oder Hybridfahrzeug sein.

Die Erfindung wird nun im Folgenden anhand von Figuren und weiteren Ausführungsbeispielen beschrieben. Weitere vorteilhafte Ausführungsvarianten ergeben sich aus einer Kombination der in den Figuren und in den abhängigen Ansprüchen beschriebenen Merkmalen.

Figur 1 zeigt ein Ausführungsbeispiel für einen Inverter, welcher sechsphasig ausgebildet ist und ausgebildet ist, sechs Statorspulen einer elektrischen Maschine zu bestromen;

Figur 2 zeigt den in Figur 1 dargestellten Inverter in einer Schnittdarstellung, wobei der Kühlkörper ein von elektronischen Komponenten des Inverters gemeinsam genutztes Massepotential bildet.

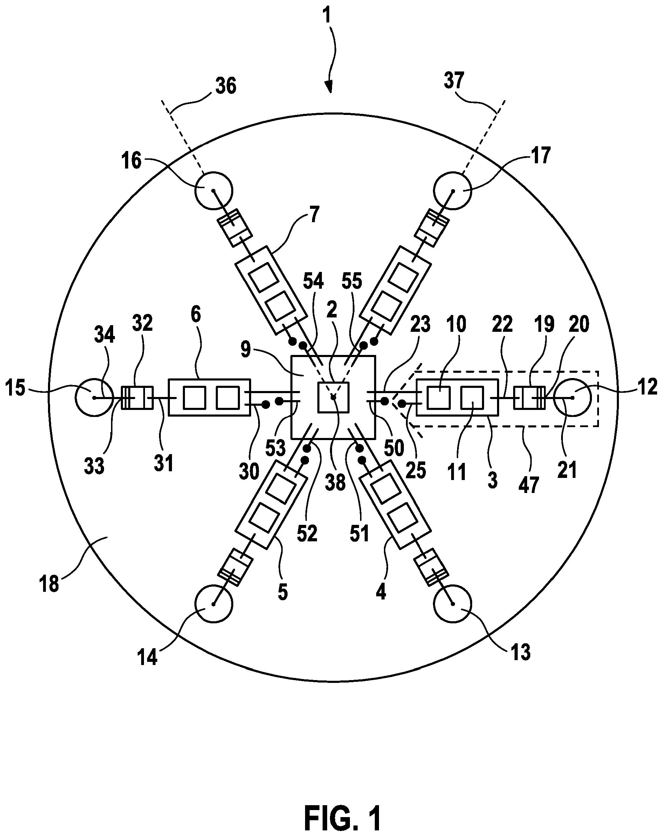

Figur 1 zeigt - schematisch - ein Ausführungsbeispiel für einen Inverter 1 in einer Aufsicht. Der Inverter 1 weist eine Steuereinheit 2 auf. Die Steuereinheit 2 weist beispielsweise einen Mikroprozessor, einen Mikrocontroller, ein ASIC (ASIC = Application-Specific-Integrated-Circuit) oder ein FPGA (FPGA = Field-Programmable-Gate-Array) auf und ist ausgebildet, insbesondere pulsweitenmodulierte Steuersignale zum Ansteuern einer Leistungsendstufe zu erzeugen. Der Inverter 1 ist in diesem Ausführungsbeispiel sechsphasig ausgebildet und weist für jede Phase eine Halbleiterschalter-Halbbrücke und einen Zwischenkreiskondensator auf. Der Inverter 1 weist dazu eine Halbleiterschalter-Halbbrücke 3, eine Halbleiterschalter-Halbbrücke 4, eine Halbleiterschalter-Halbbrücke 5, eine Halbleiterschalter-Halbbrücke 6, eine Halbleiterschalter-Halbbrücke 7 und eine Halbleiterschalter-Halbbrücke 8 auf. Die Halbleiterschalter-Halbbrücken 3, 4, 5, 6, 7 und 8 bilden gemeinsam eine Leistungsendstufe des Inverters 1. Die Halbleiterschalter-Halbbrücken 3, 4, 5, 6, 7 und 8 sind jeweils mittels wenigstens einer elektrischen Verbindungsleitung oder mehreren elektrischen Verbindungsleitungen, insbesondere einer BondDraht- oder Bond-Bandverbindung, mit einer Steuereinheit 2 verbunden und können jeweils über die elektrische Verbindung ein Steuersignal von der Steuereinheit zum Ansteuern der Halbleiterschalter-Halbbrücke, insbesondere von Steueranschlüssen der Halbbrücke, empfangen. Die Halbleiterschalter-Halbbrücken können in Abhängigkeit des Steuersignals einen Stator, insbesondere Statorspulen einer in Figur 1 nicht dargestellten elektrischen Maschine bestromen. Die Steuereinheit 2 ist ausgebildet, ein insbesondere pulsweitenmoduliertes Ansteuersignal zum mittelbaren Erzeugen eines magnetischen Drehfeldes zu erzeugen und dieses an die Halbleiterschalter-Halbbrücken zu senden. Das Steuersignal repräsentiert beispielsweise ein Sinussignal.

Die Halbleiterschalter-Halbbrücke 3 weist einen High-Side-Halbleiterschalter 10 und einen Low-Side-Halbleiterschalter 11 auf. Die Halbleiterschalter 10 und 11 sind beispielsweise durch einen Feldeffekttransistor, insbesondere MOS-FET, oder MIS-FET (MIS = Metal-Insulated-Transistor), oder einen IGBT (IGBT = Insulated-Gate-Bipolar-Transistor), oder einen HEMT-Transistor (HEMT = High-Electron-Mobility-Transistor) gebildet. Die Halbleiterschalter-Halbbrücke 3 ist ausgangsseitig über eine elektrische Verbindung 22 mit einem Stanzgitter 19 verbunden. Das Stanzgitter 19, insbesondere ein Kupferstanzteil, weist eine Drahtaufnahme 20, insbesondere Schneid-Klemm-Verbindung oder Zwinge auf, wobei die Drahtaufnahme 20 ausgebildet ist, mit einem elektrischen Anschluss 21, insbesondere einem Anschlussdraht, eines Zwischenkreiskondensators 12 verbunden, insbesondere kaltverschweißt oder laserverschweißt zu werden. Die Halbleiterschalter-Halbbrücke 3 ist ausgangsseitig mittels einer Bond-Drahtverbindung 22, insbesondere Bond-Bandverbindung, mit dem Stanzgitter 19 verbunden.

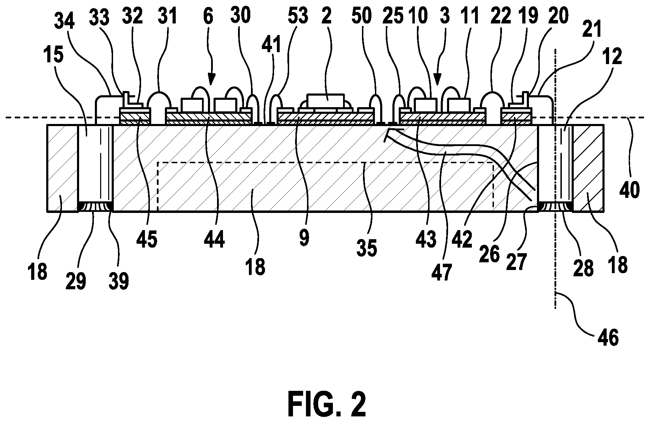

Der Inverter 1 weist auch für die übrigen Phasen jeweils einen Zwischenkreiskondensator auf. Dazu ist ein Zwischenkreiskondensator 13 mit der Halbleiterschalter-Halbbrücke 4 verbunden, ein Zwischenkreiskondensator 14 mit der Halbleiterschalter-Halbbrücke 5 verbunden, ein Zwischenkreiskondensator 15 mit der Halbleiterschalter-Halbbrücke 6 verbunden und ein Zwischenkreiskondensator 16 mit einer Halbleiterschalter-Halbbrücke 7 verbunden und ein Zwischenkreiskondensator 17 mit einer Halbleiterschalter-Halbbrücke 8 verbunden. Die Halbleiterschalter-Halbbrücken und die mit den Halbleiterschalter-Halbbrücken jeweils verbundenen Zwischenkreiskondensatoren sind jeweils auf einer von einem Zentrum 38 ausgehenden, sich vom Zentrum radial nach außen erstreckenden Radialgeraden angeordnet, im Folgenden auch Radial genannt. Ein Radial 36, welches sich von dem Zentrum 38 ausgehend erstreckt, wobei auf dem Radial 36 der Zwischenkreiskondensator 16 und die Halbleiterschalter-Halbbrücke 7 angeordnet sind, ist beispielhaft bezeichnet. Der Zwischenkreiskondensator 17 und die Halbleiterschalter-Halbbrücke 8 erstrecken sich auf einem Radial 37, welches zu dem Radial 36 in Umlaufrichtung um das Zentrum 38 umlaufend benachbart erstreckt. Die Massestrompfade im Kühlkörper 18 sind so kurz ausgebildet, so dass eine Kommutierzelle, umfassend eine Halbleiterschalter-Halbbrücke und einen Zwischenkreiskondensator für eine Phase, niederinduktiv ausgebildet ist. Die Radiale 36 und 37 schließen so einen Winkel zwischeneinander ein und erstrecken sich in diesem Ausführungsbeispiel in einer in Figur 2 näher dargestellten Verdrahtungsebene 40. Die Radiale 36 und 37, welche zueinander benachbart angeordnet sind, schließen so beispielsweise einen Winkel von 60 Grad zwischeneinander ein.

Die Halbleiterschalter-Halbbrücken sind jeweils mit der Steuereinheit 2 mittels einer elektrischen Verbindungsleitung verbunden und können über die Verbindungsleitung die Steuersignale, erzeugt durch die Steuereinheit 2, empfangen. Eine elektrische Verbindungsleitung 23, welche die Steuereinheit 2 mit der Halbleiterschalter-Halbbrücke 3 verbindet, ist beispielhaft bezeichnet.

Der Inverter 1 weist auch eine Wärmesenke 18, insbesondere einen Kühlkörper, auf. Die Halbleiterschalter-Halbbrücken 3, 4, 5, 6, 7 und 8 sind jeweils mittels einer elektrischen Verbindung, insbesondere einer Bond-Drahtverbindung oder Bond-Bandverbindung, mit der Wärmesenke 18 elektrisch verbunden. Eine Masseverbindung 25, gebildet durch eine Bond-Bandverbindung 25, welche die Halbleiterschalter-Halbbrücke 3 mit der Wärmesenke 18 verbindet, und eine Bond-Bandverbindung 30, welche die Halbleiterschalter-Halbbrücke 6 mit der Wärmesenke 18 verbindet ist beispielhaft bezeichnet. Die Halbleiterschalter-Halbbrücken sind in diesem Ausführungsbeispiel jeweils mit dem Low-Side-Halbleiterschalter, insbesondere einem Source-Anschluss des Low-Side-Halbleiterschalters der Halbbrücke, mit der Wärmesenke 18 elektrisch verbunden. Die elektrische Verbindung zur Wärmesenke 18 ist in diesem Ausführungsbeispiel im Bereich einer Radials angeordnet und weist zu Steuereinheit 2 hin. Ein in Figur 1 als gestrichelter Pfeil dargestellter Strompfad 47 vom Zwischenkreiskondensator 12 zur Halbleiterschalter-Halbbrücke 3 der sich in der Wärmesenke 18 auf dem kürzesten Weg vom Zwischenkreiskondensator 12 zur Masseverbindung 25 hin ausbildet, kann so einem positiven Leitungspfad von der Halbleiterschalter-Halbbrücke 3 zum Zwischenkreiskondensator 12 hin gegenüberliegen. Dadurch kann eine niederinduktive und verlustarme Kommutierzelle gebildet sein. Die Steuereinheit 2 ist mittels wenigstens einer elektrischen Masseverbindung, beispielsweise einer Bonddraht oder Bondbandverbindung, mit der Wärmesenke 18 elektrisch verbunden. In diesem Ausführungsbeispiel sind für jede Phase eine auf dem jeweiligen Radial liegende Masseverbindung 50, 51, 52, 53, 54 und 55 gebildet, so dass zwischen einzelnen jeweils ein Steuersignal führenden Verbindungsleitungen von der Steuereinheit 2 zu den Halbleiterschalter-Halbbrücken kein Übersprechen stattfinden kann. Die elektrische Verbindung 24 ist beispielsweise eine Bond-Drahtverbindung. Die Wärmesenke 18 bildet so eine gemeinsame Masseverbindung, und in diesem Ausführungsbeispiel auch eine Montageplattform für die mit der Wärmesenke 18 verbundenen Bauelemente des Inverters 1. Die Zwischenkreiskondensatoren 12, 13, 14, 15, 16 und 17 weisen jeweils einen Gehäusebecher auf, wobei der Gehäusebecher einen negativen elektrischen Anschluss der Zwischenkreiskondensatoren bildet, welcher mit der Wärmesenke 18 elektrisch verbunden ist. Die elektrische Verbindung ist beispielsweise eine Schweißverbindung und ist in Figur 2 im Folgenden näher dargestellt.

Figur 2 zeigt - schematisch - den in Figur 1 dargestellten Inverter 1 in einer Schnittdarstellung. Die Wärmesenke 18, welche in diesem Ausführungsbeispiel durch eine massive Metallplatte, insbesondere Aluminiumplatte oder Kupferplatte, gebildet ist, weist für die Zwischenkreiskondensatoren 12 und 15 jeweils eine Ausnehmung auf. Der Zwischenkreiskondensator 12 ist in einer Ausnehmung 28 der Wärmesenke 18 aufgenommen und der Zwischenkreiskondensator 15 ist in einer Ausnehmung 29 der Wärmesenke 18 aufgenommen. Der Zwischenkreiskondensator 12 weist einen Gehäusebecher 26 auf, welcher in diesem Ausführungsbeispiel einen negativen Anschluss des Zwischenkreiskondensators 12 bildet. Der Gehäusebecher 26 ist mit einer Innenwand der Ausnehmung 28 in der Wärmesenke 18 wärmeleitfähig mit der Wärmesenke 18 verbunden. Der Zwischenkreiskondensator 12 kann dazu beispielsweise in die Ausnehmung 28 eingepresst sein und so mit seiner Mantelfläche des Gehäusebechers 26 die Wärmesenke 18 wenigstens teilweise oder vollständig umlaufend berührend kontaktieren. Der Gehäusebecher 26 ist in diesem Ausführungsbeispiel im Bereich eines Becherbodens mittels einer Schweißverbindung 27, insbesondere einer Schweißnaht oder Schweißraupe, mit der Wärmesenke 18 verschweißt. Der Zwischenkreiskondensator 12 ist so mit der Wärmesenke 18 stoffschlüssig elektrisch und mechanisch verbunden. Der Zwischenkreiskondensator 15 ist mittels einer Schweißverbindung 39 im Bereich eines Becherbodens des Zwischenkreiskondensators 15 mit der Wärmesenke 18 schweißverbunden.

Die Wärmesenke 18 kann in einer Variante eine Ausnehmung 35 aufweisen, welche in Figur 2 gestrichelt dargestellt ist. Die Ausnehmung 35 erstreckt sich zwischen den Zwischenkreiskondensatoren 12 und 15, welche jeweils entlang eines Radials von zwei zueinander koaxial verlaufenden Radialen angeordnet sind. Die Wärmesenke 18 bildet so eine Kühlplatte, an die zur Aufnahme der Zwischenkreiskondensatoren 12 und 15 jeweils ein Kühlbecher oder Kühlhohlzylinder angeformt ist.

Die Wärmesenke 18 weist in diesem Ausführungsbeispiel auch eine sich insbesondere eben erstreckende Wärmekontaktfläche 41 auf, wobei die elektrischen Bauelemente des Inverters 1, wie in Figur 1 bereits beschrieben, mit der Wärmekontaktfläche 41 wärmeleitfähig verbunden sind.

Die Steuereinheit 2 ist in diesem Ausführungsbeispiel mit einem Schaltungsträger 9 verbunden. Der Schaltungsträger 9 ist beispielsweise als DBC-Substrat oder LTCC-Substrat ausgebildet. Die Steuereinheit 2 ist mittels der Verbindungsleitung 23 ausgangsseitig mit der Halbleiterschalter-Halbbrücke 3 verbunden. Die Halbleiterschalter-Halbbrücke 3 ist mittels einer Bond-Drahtverbindung 22 mit einem Schaltungsträger 42 verbunden, auf dem das Stanzgitter 19 mit der Drahtaufnahme 20, insbesondere Schneid-Klemm-Verbindung oder Zwinge angeordnet ist. Das Stanzgitter 19 ist mit dem Schaltungsträger 42 lötverbunden. Der positive Anschluss des Zwischenkreiskondensators 12, gebildet durch den Anschlussdraht 21, ist mit der Drahtaufnahme 20 elektrisch verbunden, sodass der Zwischenkreiskondensator 12 mit seinem positiven Anschluss über die Drahtaufnahme 20, das Stanzgitter 19, den Schaltungsträger 42 und die Bond-Drahtverbindung 22 mit der Halbleiterschalter-Halbbrücke 3 verbunden ist. Der Anschlussdraht 21 kann in einer anderen Ausführungsform mit dem Stanzgitter verschweißt sein.

Der Zwischenkreiskondensator 15 weist einen positiven Anschluss auf, welcher durch einen Anschlussdraht 34 gebildet ist. Der Anschlussdraht 34 ist mittels eines Stanzgitters 32 und einer an das Stanzgitter 32 angeformten Drahtaufnahme 33 mit dem Stanzgitter 32 elektrisch verbunden. Der Anschlussdraht 34 kann mit der Drahtaufnahme 20 verschweißt sein.

Das Stanzgitter 32 ist mittels einer Bond-Drahtverbindung 31 mit der Halbleiterschalter-Halbbrücke 6 elektrisch verbunden. Der Zwischenkreiskondensator 15 steht so elektrisch mit der Phase in Verbindung, welche durch die Halbleiterschalter-Halbbrücke 6 gebildet ist.

Die Halbleiterschalter-Halbbrücke 3 umfasst in diesem Ausführungsbeispiel einen Schaltungsträger 43, welcher beispielsweise durch einen keramischen Schaltungsträger, insbesondere ein DBC-Substrat oder LTCC-Substrat, gebildet ist. Die Halbleiterschalter 10 und 11 sind mit dem Schaltungsträger 43 elektrisch verbunden, beispielsweise lotverbunden. Die Halbleiterschalter-Halbbrücke 6 umfasst einen Schaltungsträger 44, mit dem die Halbleiterschalter-Halbbrücke 6 verbunden sind. Das Stanzgitter 32 ist mittels eines mit dem Stanzgitter 32 verlöteten Schaltungsträgers 45 mit der Wärmesenke 18 verbunden. Die Schaltungsträger 9, 42, 43, 44 und 45 sind jeweils mit der Wärmekontaktfläche 41 wärmeleitfähig verbunden und können dazu jeweils mittels eines Wärmeleitklebstoffs mit der Wärmekontaktfläche 41, und so mit der Wärmesenke 18, wärmeleitfähig verbunden sein. Von den Halbleiterschalter-Halbbrücken 3 und 6, und auch von der Steuereinheit 2 erzeugte Verlustwärme kann so an die Wärmesenke 18 abgeführt werden. Die von den Zwischenkreiskondensatoren 12 und 15 erzeugte Verlustwärme kann über die Schweißverbindung 27 beziehungsweise die Schweißverbindung 39 vom Gehäusebecher an die Wärmesenke 18 abgegeben werden oder zusätzlich über den Berührkontakt zwischen dem Gehäusebecher des jeweiligen Zwischenkreiskondensators und der Innenwand der Ausnehmung in der Wärmesenke 18. Die Schaltungsträger 42, 43, 9, 44 und 45 sind jeweils in einer Verdrahtungsebene 40 angeordnet, welche sich parallel zur Wärmekontaktfläche 41 erstreckt. Eine Zentralachse 46 des Zwischenkreiskondensators 12 erstreckt sich quer zur Verdrahtungsebene und so auch quer zur Wärmekontaktfläche 41. Die elektromagnetischen Felder, welche durch die Verbindungsleitungen, insbesondere die Bond-Verbindungen 22, 23, 30 und 31, erzeugt werden, können so mit den jeweiligen in der Wärmesenke 18 fließenden, gegenüberliegenden Strömen, beispielsweise dem Strom 47, die jeweils erzeugten elektromagnetischen Felder einander kompensieren. Der Strom 47, - insbesondere Massestrom - in der Wärmesenke 18 kann auch zum Masseanschluss 50 der Steuereinheit 2 fließen, wobei der Masseanschluss 50 die Steuereinheit 2 mit der Wärmesenke 18 verbindet.

## Patentansprüche

1. Inverter (1) mit wenigstens drei Phasen zum Bestromen einer elektrischen Maschine,
wobei der Inverter (1) eine Steuereinheit (2) und wenigstens eine eingangsseitig mit der Steuereinheit (2) verbundene, Halbleiterschalter-Halbbrücken (3, 4, 5, 6, 7, 8) aufweisende Leistungsendstufe aufweist, wobei die Steuereinheit (2) ausgebildet ist, insbesondere pulsweitenmodulierte Steuersignale zum Ansteuern der Leistungsendstufe zu erzeugen, wobei die Leistungsendstufe ausgebildet ist, die elektrische Maschine in Abhängigkeit des Steuersignals zu bestromen, wobei der Inverter einen Kühlkörper (18) und für jede Phase einen Zwischenkreiskondensator (12, 13, 14, 15, 16, 17) und eine Halbleiterschalter-Halbbrücke (3, 4, 5, 6, 7, 8) aufweist, wobei der Kühlkörper (18) eine ebene Wärmekontaktfläche (41) aufweist, wobei die Wärmekontaktfläche (41) mit der Steuereinheit (2) und mit den Halbleiterschalter-Halbbrücken (3, 4, 5, 6, 7, 8) wärmeleitfähig verbunden ist, und wobei der Kühlkörper (18) für die Zwischenkreiskondensatoren (12, 13, 14, 15, 16, 17) jeweils eine Ausnehmung (28, 29) aufweist und die Zwischenkreiskondensatoren (12, 13, 14, 15, 16, 17) jeweils in einer Ausnehmung (28, 29) des Kühlkörpers (18) angeordnet sind, wobei ein einer Phase zugeordneter Zwischenkreiskondensator (12, 13, 14, 15, 16, 17) und eine Halbleiterschalterhalbbrücke (3, 4, 5, 6, 7, 8) gemeinsam auf einer Radialverbindung (36, 37) zur Steuereinheit (2) hin angeordnet sind, wobei die Zwischenkreiskondensatoren jeweils zylinderförmig ausgebildet sind, und wobei eine Zentralachse (46) der Zwischenkreiskondensatoren (12, 13, 14, 15, 16, 17) jeweils quer zu einer flachen Erstreckung der Wärmekontaktfläche (41) verläuft,
**dadurch gekennzeichnet, dass** die Masseanschlüsse (25, 26) der Zwischenkreiskondensatoren (12, 13, 14, 15, 16, 17) und der Halbleiterschalter-Halbbrücken jeweils mit dem Kühlkörper (18) verbunden sind, ein Kondensatorbecher (26) des Zwischenkreiskondensators (12, 13, 14, 15, 16, 17) mit dem Kühlkörper (18) elektrisch verbunden ist, und zwar derart, dass Masseströme von oder zu dem Zwischenkreiskondensator (12, 13, 14, 15, 16, 17) fließen können.

2. Inverter (1) nach Anspruch 1,
**dadurch gekennzeichnet, dass**
die elektrischen Verbindungen (19, 22) zwischen der Halbleiterschalter-Halbbrücke 3, 4, 5, 6, 7, 8) und dem Zwischenkreiskondensator (12, 13, 14, 15, 16, 17) in einer Verdrahtungsebene (40) verlaufen, die sich parallel zur Wärmekontaktfläche (41) erstreckt.

3. Inverter (1) nach einem der vorhergehenden Ansprüche,
**dadurch gekennzeichnet, dass**
ein insbesondere positiver Stromleitungspfad (22, 30) einer Phase von der Halbleiterschalter-Halbbrücke (3, 4, 5, 6, 7, 8) zum Zwischenkreiskondensator (12, 13, 14, 15, 16, 17) und/oder in der Verdrahtungsebene (40) auf der Radialverbindung (36, 37) zur Steuereinheit (2) hin verläuft.

4. Inverter (1) nach einem der vorhergehenden Ansprüche,
**dadurch gekennzeichnet, dass**
ein insbesondere positiver Signalpfad einer Phase von der Steuereinheit zur Halbleiterschalter-Halbbrücke (3, 4, 5, 6, 7, 8) in der Verdrahtungsebene (40) und/oder auf der Radialverbindung (36, 37) zur Halbleiterschalter-Halbbrücke (3, 4, 5, 6, 7, 8) hin verläuft.

5. Inverter (1) nach einem der vorhergehenden Ansprüche,
**dadurch gekennzeichnet, dass**
der Zwischenkreiskondensator (12, 13, 14, 15, 16, 17) einen Kondensatorwickel aufweist, welcher in der Ausnehmung (28, 29) angeordnet ist, so dass die Ausnehmung einen Kondensatorbecher des Zwischenkreiskondensators (12, 13, 14, 15, 16, 17) bildet.

6. Inverter (1) nach einem der vorhergehenden Ansprüche,
**dadurch gekennzeichnet, dass**
die Steuereinheit und die Radialverbindungen zu den Halbleiterschalter-Halbbrücken hin eine sternförmige Verbindungsanordnung bildet, wobei ein Masseanschluss (24) der Steuereinheit (2) im Bereich des Zentrums (28) der Verbindungsanordnung angeordnet ist.

7. Inverter (1) nach einem der vorhergehenden Ansprüche,
**dadurch gekennzeichnet, dass**
der Kühlkörper (18) eine Masseverbindung zwischen der Steuereinheit (2) und den Halbleiterschalter-Halbbrücken (3, 4, 5, 6, 7, 8) und den Zwischenkreiskondensatoren (12, 13, 14, 15, 16, 17) bildet, so dass die Masseströme über den Kühlkörper fließen können.

8. Inverter (1) nach einem der vorhergehenden Ansprüche,
**dadurch gekennzeichnet, dass**
der Kühlkörper (18) eine Kühlplatte aufweist, wobei an die Kühlplatte Kühlbecher oder Kühlzylinder zur Aufnahme der Zwischenkreiskondensatoren (12, 13, 14, 15, 16, 17) angeformt sind.

9. Inverter (1) nach einem der vorhergehenden Ansprüche,
**dadurch gekennzeichnet, dass**
die Zentralachsen (46) der Zwischenkreiskondensatoren (12, 13, 14, 15, 16, 17) sich jeweils quer zur Verdrahtungsebene (40) erstrecken.

## Claims

1. Inverter (1) having at least three phases for energizing an electric machine,
wherein the inverter (1) has a control unit (2) and at least one power output stage having semiconductor-switch half-bridges (3, 4, 5, 6, 7, 8) that are connected at input to the control unit (2), wherein the control unit (2) is designed to generate in particular pulse width-modulated control signals for driving the power output stage, wherein the power output stage is designed to energize the electric machine on the basis of the control signal, wherein the inverter has a heat sink (18) and, for each phase, an intermediate circuit capacitor (12, 13, 14, 15, 16, 17) and a semiconductor-switch half-bridge (3, 4, 5, 6, 7, 8), wherein the heat sink (18) has a flat thermal contact surface (41), wherein the thermal contact surface (41) is thermally conductively connected to the control unit (2) and to the semiconductor-switch half-bridges (3, 4, 5, 6, 7, 8), and wherein the heat sink (18) has a respective recess (28, 29) for the intermediate circuit capacitors (12, 13, 14, 15, 16, 17) and the intermediate circuit capacitors (12, 13, 14, 15, 16, 17) are each arranged in a recess (28, 29) of the heat sink (18), wherein an intermediate circuit capacitor (12, 13, 14, 15, 16, 17) assigned to a phase and a semiconductor-switch half-bridge (3, 4, 5, 6, 7, 8) are arranged together on a radial connection (36, 37) towards the control unit (2), wherein the intermediate circuit capacitors are each of cylindrical design, and wherein a central axis (46) of the intermediate circuit capacitors (12, 13, 14, 15, 16, 17) runs in each case transverse to a flat extent of the thermal contact surface (41), **characterized in that** the ground terminals (25, 26) of the intermediate circuit capacitors (12, 13, 14, 15, 16, 17) and of the semiconductor-switch half-bridges are each connected to the heat sink (18), and a capacitor can (26) of the intermediate circuit capacitor (12, 13, 14, 15, 16, 17) is electrically connected to the heat sink (18), specifically in such a way that ground currents are able to flow from or to the intermediate circuit capacitor (12, 13, 14, 15, 16, 17).

2. Inverter (1) according to Claim 1,
**characterized in that**
the electrical connections (19, 22) run between the semiconductor-switch half-bridge (3, 4, 5, 6, 7, 8) and the intermediate circuit capacitor (12, 13, 14, 15, 16, 17) in a wiring plane (40) that extends parallel to the thermal contact surface (41).

3. Inverter (1) according to either of the preceding claims,
**characterized in that**
an in particular positive current conduction path (22, 30) of a phase runs from the semiconductor-switch half-bridge (3, 4, 5, 6, 7, 8) to the intermediate circuit capacitor (12, 13, 14, 15, 16, 17) and/or in the wiring plane (40) on the radial connection (36, 37) towards the control unit (2).

4. Inverter (1) according to either of the preceding claims,
**characterized in that**
an in particular positive signal path of a phase runs from the control unit to the semiconductor-switch half-bridge (3, 4, 5, 6, 7, 8) in the wiring plane (40) and/or on the radial connection (36, 37) towards the semiconductor-switch half-bridge (3, 4, 5, 6, 7, 8).

5. Inverter (1) according to either of the preceding claims,
**characterized in that**
the intermediate circuit capacitor (12, 13, 14, 15, 16, 17) has a capacitor winding that is arranged in the recess (28, 29) such that the recess forms a capacitor can of the intermediate circuit capacitor (12, 13, 14, 15, 16, 17) .

6. Inverter (1) according to either of the preceding claims,
**characterized in that**
the control unit and the radial connections towards the semiconductor-switch half-bridges form a star-shaped connection arrangement, wherein a ground terminal (24) of the control unit (2) is arranged in the region of the centre (28) of the connection arrangement.

7. Inverter (1) according to either of the preceding claims,
**characterized in that**
the heat sink (18) forms a ground connection between the control unit (2) and the semiconductor-switch half-bridges (3, 4, 5, 6, 7, 8) and the intermediate circuit capacitors (12, 13, 14, 15, 16, 17), such that the ground currents are able to flow through the heat sink.

8. Inverter (1) according to either of the preceding claims,
**characterized in that**
the heat sink (18) has a cooling plate, wherein cooling cans or cooling cylinders for receiving the intermediate circuit capacitors (12, 13, 14, 15, 16, 17) are fitted onto the cooling plate.

9. Inverter (1) according to either of the preceding claims,
**characterized in that**
the central axes (46) of the intermediate circuit capacitors (12, 13, 14, 15, 16, 17) each extend transverse to the wiring plane (40).

## Revendications

1. Inverseur (1) à au moins trois phases pour alimenter une machine électrique,
l'inverseur (1) présentant une unité de commande (2) et au moins un étage final de puissance présentant des demi-ponts de commutation à semi-conducteurs (3, 4, 5, 6, 7, 8) reliés côté entrée à l'unité de commande (2), l'unité de commande (2) étant conçue pour générer en particulier des signaux de commande modulés en largeur d'impulsion afin de commander l'étage final de puissance, l'étage final de puissance étant conçu pour alimenter la machine électrique en fonction du signal de commande, l'inverseur comprenant un corps de refroidissement (18) et, pour chaque phase, un condensateur de circuit intermédiaire (12, 13, 14, 15, 16, 17) et un demi-pont de commutation à semi-conducteurs (3, 4, 5, 6, 7, 8), le corps de refroidissement (18) présentant une surface de contact thermique plane (41), la surface de contact thermique (41) étant reliée de manière thermoconductrice à l'unité de commande (2) et aux demi-ponts de commutation à semi-conducteurs (3, 4, 5, 6, 7, 8), et le corps de refroidissement (18) présentant un évidement (28, 29) pour chacun des condensateurs de circuit intermédiaire (12, 13, 14, 15, 16, 17) et les condensateurs de circuit intermédiaire (12, 13, 14, 15, 16, 17) sont disposés chacun dans un évidement (28, 29) du corps de refroidissement (18),
un condensateur de circuit intermédiaire (12, 13, 14, 15, 16, 17) associé à une phase et un demi-pont de commutation à semi-conducteurs (3, 4, 5, 6, 7, 8) sont agencés ensemble sur une connexion radiale (36, 37) à l'unité de commande (2), les condensateurs de circuit intermédiaire étant chacun de forme cylindrique, et un axe central (46) respectif des condensateurs de circuit intermédiaire (12, 13, 14, 15, 16, 17) s'étendant transversalement à une extension plate de la surface de contact thermique (41), **caractérisé en ce que** les connexions à la masse (25, 26) des condensateurs de circuit intermédiaire (12, 13, 14, 15, 16, 17) et des demi-ponts de commutation à semi-conducteurs sont respectivement connectées au corps de refroidissement (18),
un godet de condensateur (26) du condensateur de circuit intermédiaire (12, 13, 14, 15, 16, 17) est connecté électriquement au corps de refroidissement (18) de telle sorte que des courants de masse soient aptes à circuler depuis le condensateur de circuit intermédiaire (12, 13, 14, 15, 16, 17) ou vers celui-ci.

2. Inverseur (1) selon la revendication 1,
**caractérisé en ce que**
les connexions électriques (19, 22) entre le demi-pont de commutation à semi-conducteurs (3, 4, 5, 6, 7, 8) et le condensateur de circuit intermédiaire (12, 13, 14, 15, 16, 17) s'étendent dans un plan de câblage (40) qui s'étend de façon parallèle à la surface de contact thermique (41).

3. Inverseur (1) selon l'une des revendications précédentes,
**caractérisé en ce que**
un chemin de conduction de courant (22, 30) d'une phase, en particulier positive, allant du demi-pont de commutation à semi-conducteurs (3, 4, 5, 6, 7, 8) au condensateur de circuit intermédiaire (12, 13, 14, 15, 16, 17) et/ou dans le plan de câblage (40) sur la connexion radiale (36, 37) s'étend vers l'unité de commande (2).

4. Inverseur (1) selon l'une des revendications précédentes,
**caractérisé en ce que**
un chemin de signal d'une phase, en particulier positive, allant de l'unité de commande au demi-pont de commutation à semi-conducteurs (3, 4, 5, 6, 7, 8) dans le plan de câblage (40) et/ou sur la connexion radiale (36, 37) s'étend vers le demi-pont de commutation à semi-conducteurs (3, 4, 5, 6, 7, 8).

5. Inverseur (1) selon l'une des revendications précédentes,
**caractérisé en ce que**
le condensateur de circuit intermédiaire (12, 13, 14, 15, 16, 17) comprend un enroulement de condensateur qui est agencé dans l'évidement (28, 29) de sorte que l'évidement forme un godet de condensateur du condensateur de circuit intermédiaire (12, 13, 14, 15, 16, 17).

6. Inverseur (1) selon l'une des revendications précédentes,
**caractérisé en ce que**
l'unité de commande et les connexions radiales vers les demi-ponts de commutation à semi-conducteurs forment un agencement de connexion en forme d'étoile, une connexion de masse (24) de l'unité de commande (2) étant agencée dans la zone du centre (28) de l'agencement de connexion.

7. Inverseur (1) selon l'une des revendications précédentes,
**caractérisé en ce que**
le corps de refroidissement (18) forme une connexion à la masse entre l'unité de commande (2) et les demi-ponts de commutation à semi-conducteurs (3, 4, 5, 6, 7, 8) et les condensateurs de circuit intermédiaire (12, 13, 14, 15, 16, 17), de sorte que les courants de masse soient aptes à circuler à travers le corps de refroidissement.

8. Inverseur (1) selon l'une des revendications précédentes,
**caractérisé en ce que**
le corps de refroidissement (18) comporte une plaque de refroidissement, avec des godets de refroidissement ou des cylindres de refroidissement destinés à recevoir les condensateurs de circuit intermédiaire (12, 13, 14, 15, 16, 17) formés sur la plaque de refroidissement.

9. Inverseur (1) selon l'une des revendications précédentes,
**caractérisé en ce que**
les axes centraux (46) des condensateurs de circuit intermédiaire (12, 13, 14, 15, 16, 17) s'étendent chacun transversalement au niveau du plan de câblage (40).
